# EUROPEAN PATENT SPECIFICATION

(11) **EP 0 832 341 B1**
(45) Date of publication and mention of the grant of the patent: **24.10.2001**
(21) Application number: 96906787.5
(22) Date of filing: 22.03.1996
(51) Int. Cl.: E05B 17/00, E05B 1/00, E05B 65/00, E06B 5/16

(54) **LOCKING MECHANISM FOR THE DOOR OF AN INTERFERENCE-PROTECTED SPACE**
VERSCHLUSSMECHANISMUS FÜR DIE TÜRE EINES VOR STÖRUNGEN GESCHÜTZTEN BEREICHES
MECANISME DE VERROUILLAGE POUR LA PORTE D'UN ESPACE PROTEGE CONTRE LES INTERFERENCES

(30) Priority: 23.03.1995 FI 951394
(43) Date of publication of application: 01.04.1998
(73) Proprietor: Nummela, Ari, 275 00 Kauttua (FI)
(72) Inventor: Nummela, Ari, 275 00 Kauttua (FI)
(74) Representative: Pirhonen, Kari Lennart
(86) International application number: FI9600167
(87) International publication number: WO9629491

(56) References cited:
- EP-A- 0 259 108
- DE-A- 2 065 434
- DE-B- 1 139 967
- DERWENT'S ABSTRACT, No. 87-85209/12, Week 8712; & SU,A,1 247 496, (IND BUILDING STRUCT), 30 July 1986.

## Description

The object of the invention is a locking mechanism for the door of an interference-protected space, the mechanism comprising a handle or similar opening device on either side of the door so that the door can be opened from both inside and outside, the said handles being connected to each other by a structure including a waveguide and an intermediate element made of insulating material being at least partly in the waveguide.

An interference-protected space refers to the type of space, the wall and door structures of which are constructed in such a way as to restrict the passing of electromagnetic interference through the structures. Spaces like this are commonly used, for example, in industry, research institutes and hospitals. The measuring instruments used in them are usually so sensitive that they need to be protected from external electromagnetic radiation and radio frequency interference. Correspondingly, it is also possible that protection is required to prevent the leakage outside the space of an interfering field generated by a certain device.

The efficiency of interference-protection required by different measuring instruments varies a great deal. Thus also the protective structures used for different purposes vary. The better the interference-protection is to be, the more attention must be paid to all possible interference leakage points in the structures. It is usually relatively easy to protect wall structures efficiently by adding protective layers to the walls, but doors and other lead-throughs, on the other hand, cause problems. Known solutions for sealing doors include various kinds of labyrinth packings on the edges of doors, which when added as needed always give a sufficient level of protection. In this way, however, the door easily becomes inconvenient to use and the complex packings are easily damaged.

When the required level of interference-protection rises, more and more structural details have to be protected and they thus become significant. One such detail is the locking mechanism of the door, the structure of which is normally such that some electromagnetic interference is able to pass through the structures of the door. This is due to the fact that the lock on the door then forms an antenna which conducts interference through the door.

One solution for preventing an interference field from passing through the front panel of a door into a protected space is disclosed in Finnish patent number 63992. In this solution, a highly conductive contact plate is incorporated in the rotating shaft of a door handle, the surface of the said plate rubbing on a plate below, which is fixed to the front panel of the door, when the handle is turned. In this way, the electromagnetic interference coming through the handle can be conducted to the metal surface panel of the door, thus reducing the antenna-effect of the handle. In this way it is not, however, possible to completely eliminate the interference leakage caused by the door handle and locking device.

In the prior art the document EP-A-0 259 108 discloses a door locking mechanism for the door of an interference-protected space. On both sides of the door the mechanism comprises handles, which are connected to each other by an intermediate element made of an electrically insulating material. The intermediate element is passing through a conductive member to form an electromagnetic proof structure, i.e. acting as a waveguide.

The structure of that door locking mechanism is not very efficient for interference-protection because the conductive member goes straight through the door. Also the conductive member is too short compared to its diameter in order to achieve suppression of the electromagnetic interference.

The aim of the present invention is to eliminate the problem described above and to provide a new door locking mechanism which does not have the above-mentioned disadvantages. The invention is characterized as a locking mechanism for the door of an interference-protected space, the mechanism comprising a handle or similar opening device on either side of the door so that the door can be opened from both inside and outside, the said handles being connected to each other by intermediate elements including an insulating element at least partially longitudinally located inside a tubular box beam made of metal, acting as a waveguide for suppressing electromagnetic interference, which can be installed parallel with the plane of the door.

By means of the invention, the structure between the opening handles located on different sides of the door locking mechanism is prevented from conducting electromagnetic radiation or radio frequency interference through the door.

The invention is described in the following by way of an example, with reference to the appended drawings in which
- Figure 1: shows the door of an interference-protected space relating to the invention from the side.
- Figure 2: shows a cross-section of the door along line II-II of figure 1.
- Figure 3: shows a cross-section of the door locking mechanism along line III-III of figure 2.
- Figure 4: shows a section of a part of the locking device along line IV-IV of figure 3.

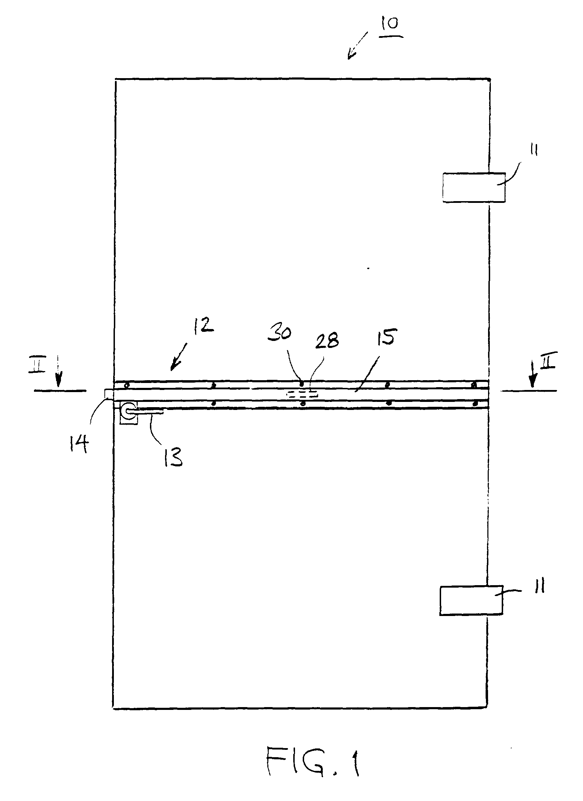

Figure 1 shows the door 10 of an interference-protected space relating to the invention, from the side. The door 10 is equipped with hinges 11 and a locking mechanism 12. Figure 1 does not, however, show the edge packings of the door 10 or other such known structures that are irrelevant to the invention disclosed in this application.

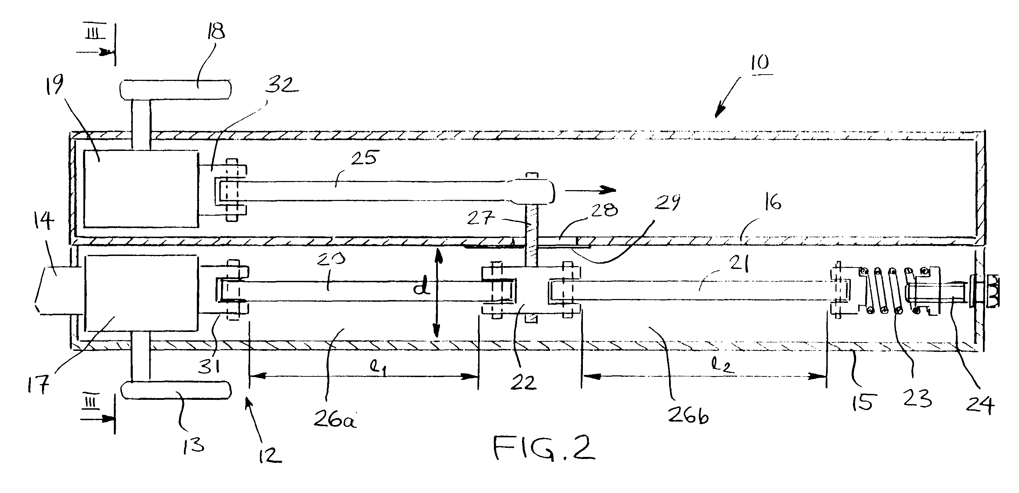

In figure 1, the locking mechanism 12 incorporates a handle 13, by pressing which the bolt 14 of the lock moves inside the mechanism in the usual manner, thus making it possible to open the door 10. The frame of the locking mechanism 12 is formed of a box beam 15 parallel with the plane of the door 10 and made of metal. In this embodiment the box beam 15 is fastened horizontally outside the actual door structure, to the metal surface panel of the door 10. The principle of the locking mechanism is described in greater detail in figure 2.

Figure 2 shows a horizontal cross-section of the locking mechanism 12 of the door 10 shown in figure 1. It appears from the figure that a metal box beam 15 is fastened outside the actual structure of the door 10, on its metal surface panel 16. The bolt 14 of the lock and its sliding mechanism 17, known as such, are at the end of this box beam 15. By pressing the handle 13, the bolt 14 of the lock is caused to move in the usual manner inside the sliding mechanism 17, thus making it possible to open the door 10.

In the embodiment shown in figures 1 and 2, the box beam 15 and handle 13 of the locking mechanism 12 are intended to be located outside the space to be protected from interference. Since it must be possible to open the door also from the opposite side, that is, from the inside of the space to be protected from interference, the locking mechanism 12 comprises a second handle 18 and its mechanism 19.

In order that the locking mechanism 12 would not form an antenna conducting interference through the door, the outside handle 13 and the inside handle 18 are not connected to each other directly by means of a connecting shaft between them. Instead, in the embodiment shown in figure 2, the mechanisms 17 and 19 relating to the inside and outside handles 13 and 18 are connected to each other through an opening 28 made on the surface panel 16, by means of intermediate elements 22, 27 and 25. The chain of intermediate elements also includes an insulation bar 20 situated inside the box beam 15 and made of, for example, PVC plastic.

In figure 2, the area 26a surrounding the insulation bar 20 in the metal box beam 15 acts as a waveguide which suppresses electromagnetic interference. It is characteristic of a waveguide that suppression is efficient when the length (1) of the waveguide 26a, that is, of the effective interference suppression area, is greater than three times the diameter (d) of the waveguide 26a. An efficient waveguide structure in which this ratio is clearly greater than three can easily be installed on the door construction. For the sake of clarity, however, this scale has been changed in figure 2 so that the cross-section of the box beam has been shown larger than it is in reality.

The insulation bar 20 inside the box beam 15 does not impair interference suppression by the waveguide 26a, because the insulation does not conduct interference. At the opposite end of the box beam 15 is a corresponding insulation bar 21, on which a spring 23 rests. Thus, interference-suppressing waveguides 26a and 26b are formed inside the box beam 15 in both directions with respect to the opening 28.

In figure 2, one end of the insulation bar 20 is connected to an intermediate slide 22, on the other side of which is the spring 23. The purpose of the spring 23 is to return the bolt 14 of the lock to the locking position after the opening movement. The springback factor can be adjusted by means of the adjuster screw 24 connected to the opposite end of the spring 23.

The inside handle 18 of the door 10 and its mechanism 19 are connected to the intermediate slide 22 in the box beam 15 outside the door 10 by means of a joining bar 25 and a spiral bar 27. On the outer surface panel 16 of the door 10 a lead-through opening 28 is formed for the spiral bar 27, the opening being covered by a protective plate 29 made of stainless steel connected to the spiral bar 27.

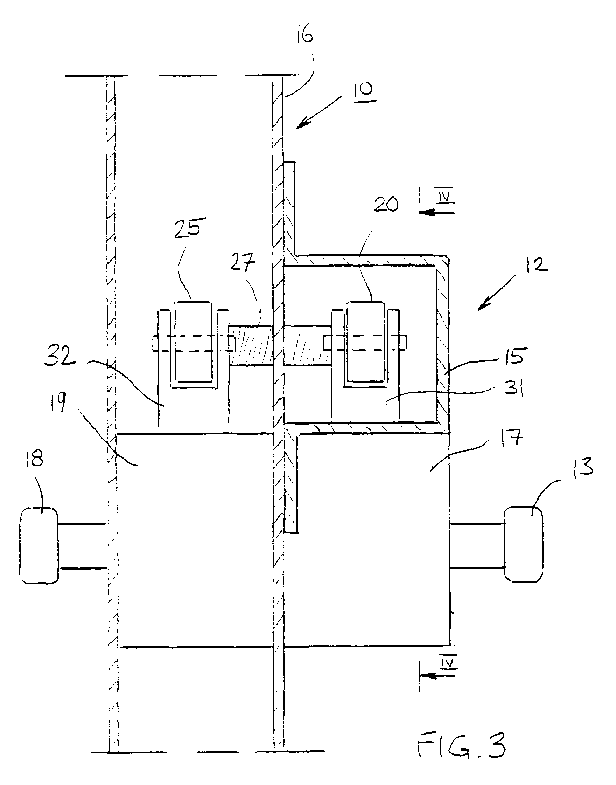

Figure 3 shows a vertical cross-section of the locking mechanism 12 of the door 10. It appears from the figure that a metal box beam 15, which forms a waveguide suppressing interference, is fastened to the metal outer surface panel 16 of the door 10. The mechanism 17 of the outside handle 13 of the door 10 moves the insulation bar 20 in the box beam 15 by means of a lever 31, the said bar also being connected to the lever 32 of the mechanism 19 of the inside handle 18 of the door 10 by means of an intermediate element 27.

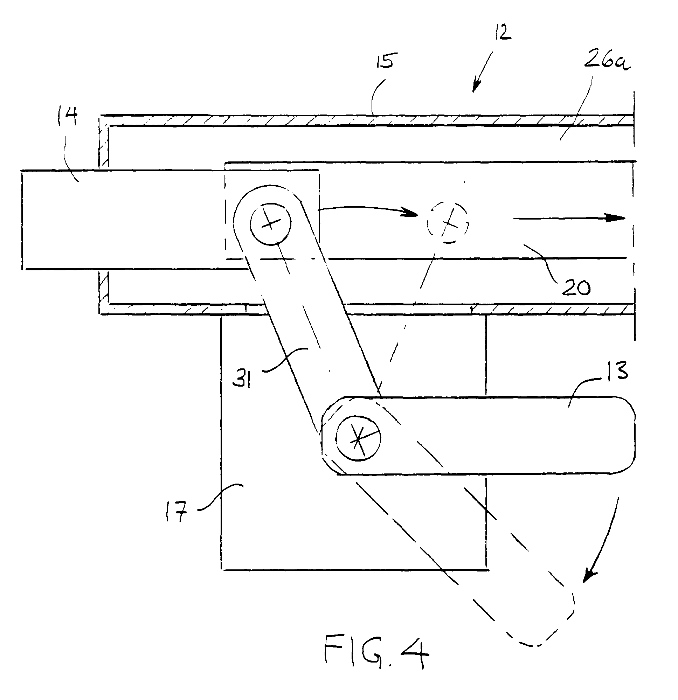

Figure 4 shows a vertical cross-section of a part of the locking device 12 from another direction. The outside handle 13 of the door moves the bolt 14 of the lock in the usual manner by means of the lever 31 incorporated in the mechanism 17. To allow the door to be opened also from the other side, the inside and outside mechanisms are connected to each other by means of the insulation bar 20 inside the waveguide 26a formed by the box beam 15.

Figure 1 further shows that the opening 28 formed on the outer surface panel of the door 10, inside the box beam 15, is situated as close to the centrepoint of the box beam 15 as possible. In this way the distance of the opening 28 from both ends of the box beam 15 becomes sufficiently long. Thus the interference passing into the waveguides formed inside the box beam are suppressed effectively. The box beam 15 is fastened to the outer surface panel of the door 10 with screws 30 placed sufficiently close to each other in order to form as tightly sealed a waveguide as possible. This is why the centremost screws 30 are situated precisely at the opening 28. The area around the opening 28 is obviously the most critical, which means that this is where the box beam has to be equipped with interference protection packing. If necessary, it may also be possible to use a welded joint.

As regards figures 2-4 it should be noted that they only depict the principle of the locking mechanism relating to the invention and its operating elements diagrammatically. For the sake of clarity, all the elements have been simplified. This is also why the dimensions of the structures shown are not correct. Neither do the figures show the labyrinth packings or the like, which are an essential part of the door and correspondingly the door frame, because they are not a part of the invention concerning the door locking mechanism.

It is obvious to a person skilled in the art that the different embodiments of the invention may vary within the scope of the claims presented below.

## Claims

1. A locking mechanism (12) for the door (10) of an interference-protected space, the mechanism comprising a handle (13, 18) or similar opening device on either side of the door so that the door can be opened from both inside and outside, the said handles being connected to each other by intermediate elements (20, 22, 25, 27) including an insulating element (20) at least partially longitudinally located inside a tubular box beam (15) made of metal, acting as a waveguide for suppressing electromagnetic interference, which can be installed parallel with the plane of the door (10).

2. A locking mechanism as claimed in claim 1, **characterized in that** the tubular box beam (15) is located on the surface of the door (10), and the intermediate element (20) made of insulating material is an insulation bar located inside the tubular box beam.

3. A locking mechanism as claimed in claim 1 or 2, **characterized in that** the length (1) of the tubular waveguide (26a) made of metal is greater than three times the diameter (d) of the waveguide.

4. A locking mechanism as claimed in claim 1, 2 or 3, **characterized in that** the tubular part (15) of the locking mechanism (12) is comprised of a metal trough connected to the metal surface of the door (10), in which trough the intermediate element (20) made of insulating material is situated.

5. A locking mechanism as claimed in any of the claims 1 to 4, **characterized in that** the locking mechanism (12) comprises an opening (28) made in the surface panel (16) of the door (10), and an intermediate element (27) going through the opening, the said intermediate element connecting via other intermediate elements (20, 22, 25), the handles (13, 18) or corresponding opening devices situated on the inside and outside of the door (10) with each other.

6. A locking mechanism as claimed in claim 5, **characterized in that** a slide element (22, 27) is situated in the opening (28), the said element being connected to the mechanisms (17, 19) of the handles (13, 18) on different sides of the door (10) by means of intermediate elements (20, 25) and an insulation bar (20) made of insulating material, for example, PVC plastic.

7. A locking mechanism as claimed in claim 6, **characterized in that** a protective metal plate (29) is connected to the slide element (22, 27), which plate moves with the element and is larger than the opening (28) made on the surface panel (16) of the door (10), so that the plate covers the opening in all positions of the slide element.

## Patentansprüche

1. Verschließvorrichtung (12) für Türen (10) von störungsgesicherten Räumen, welche auf beiden Seiten der Tür einen Türdrücker (13, 18) oder ähnliche Öffnungsvorrichtung umfasst, sodass sich die Tür von beiden Seiten öffnen lässt, wobei die genannten Türdrücker mit Hilfe von Zwischenelementen (20, 22, 25, 27) miteinander verbunden sind, welche ein Isolierelement (20) umfassen, das mindestens teilweise entlang der Innenseite eines Rohrprofils (15) aus Metall verläuft, das als Hohlleiter zur Unterdrückung elektromagnetischer Störungen fungiert und parallel zur Oberfläche der Tür (10) verlaufend angeordnet werden kann.

2. Verschließvorrichtung nach Anspruch 1, **dadurch gekennzeichnet, dass** das Rohrprofil (15) an der Oberfläche der Tür (10) angeordnet ist und dass das aus einem isolierenden Material bestehende Zwischenelement (20) als Isolierstange innerhalb des Rohrprofils fungiert.

3. Verschließvorrichtung nach Anspruch 1 oder 2, **dadurch gekennzeichnet, dass** die Länge (1) des aus Metall bestehenden Hohlleiters (26a) größer ist als der dreifache Durchmesser (d) des Hohlleiters.

4. Verschließvorrichtung nach Anspruch 1, 2 oder 3, **dadurch gekennzeichnet, dass** der rohrförmige Teil (15) der Verschließvorrichtung (12) aus einer an der Metalloberfläche der Tür (10) angebrachten Metallrinne besteht, in der das aus Isoliermaterial bestehende Zwischenelement (20) verläuft.

5. Verschließvorrichtung nach einem der Ansprüche 1 bis 4, **dadurch gekennzeichnet, dass** die Verschließvorrichtung (12) eine Öffnung (28) in der Außenhaut (16) der Tür (10) sowie ein durch die Öffnung verlaufendes Zwischenelement (27) umfasst, das über weitere Zwischenelemente (20, 22, 25) die Türdrücker (13, 18) oder andere entsprechende an der Innen- und Außenseite der Tür (10) befindliche Öffnungselemente miteinander verbindet.

6. Verschließvorrichtung nach Anspruch 5, **dadurch gekennzeichnet, dass** in der Öffnung (28) ein Schieberelement (22, 27) angeordnet ist, das mit den Mechanismen (17, 19) der Türdrücker (13, 18) an den beiden Seiten der Tür (10) mit Hilfe der Zwischenelemente (20, 25) und einer Isolierstange (20) aus Isoliermaterial wie zum Beispiel PVC-Kunststoff verbunden ist.

7. Verschließvorrichtung nach Anspruch 6, **dadurch gekennzeichnet, dass** am Schieberelement (22, 27) eine Schutzplatte (29) aus Metall angeordnet ist, die sich mit dem Schieberelement bewegt und größer ist als die Öffnung (28) in der Außenhaut (16) der Tür (10), sodass die Platte die Öffnung in allen Positionen des Schieberelements abdeckt.

## Revendications

1. Mécanisme de verrouillage (12) pour la porte (10) d'un espace protégé contre les interférences, mécanisme comprenant une poignée (13,18) ou un dispositif d'ouverture similaire des deux côtés de la porte de façon à permettre l'ouverture de la porte tant de l'intérieur que de l'extérieur, lesdites poignées étant connectées l'une à l'autre à l'aide d'éléments intermédiaires (20, 22, 25, 27) comprenant un élément isolant (20) au moins partiellement inséré longitudinalement dans une poutre tubulaire (15) faite de métal et agissant comme un guide-ondes supprimant les interférences électromagnétiques et pouvant être installé parallèlement au plan de la porte (10).

2. Mécanisme de verrouillage selon la revendication 1, **caractérisé en ce que** la poutre tubulaire (15) est située sur la surface de la porte (10) et que l'élément intermédiaire (20) fait d'un matériau isolant est une barre isolante se trouvant à l'intérieur de la poutre tubulaire.

3. Mécanisme de verrouillage selon la revendication 1 ou 2, **caractérisé en ce que** la longueur (1) du guide-ondes tubulaire (26a) fait de métal est supérieure à trois fois le diamètre (d) du guide-ondes.

4. Mécanisme de verrouillage selon la revendication 1, 2 ou 3, **caractérisé en ce que** la partie tubulaire (15) du mécanisme de verrouillage (12) se compose d'un bac métallique connecté à la surface métallique de la porte (10), bac dans lequel se trouve l'élément intermédiaire (20) fait d'un matériau isolant.

5. Mécanisme de verrouillage selon l'une quelconque des revendications 1 à 4, **caractérisé en ce que** le mécanisme de verrouillage (12) comprend une ouverture (28) pratiquée dans le panneau de surface (16) de la porte (10) et un élément intermédiaire (27) traversant l'ouverture et connectant, via d'autres éléments intermédiaires (20, 22, 25), l'un à l'autre les poignées (13, 18) ou dispositifs d'ouverture correspondants situés de part et d'autre de la porte (10).

6. Mécanisme de verrouillage selon la revendication 5, **caractérisé en ce qu'**un élément coulissant (22, 27) est situé dans l'ouverture (28), ledit élément étant connecté aux mécanismes (17, 19) des poignées (13, 18) des deux côtés de la porte (10) au moyen d'éléments intermédiaires (20, 25) et d'une barre isolante (20) faite d'un matériau isolant, comme par exemple de plastique PVC.

7. Mécanisme de verrouillage selon la revendication 6, **caractérisé en ce qu'**une plaque de protection métallique (29) est connectée à l'élément coulissant (22, 27), plaque qui est solidaire avec l'élément et plus grande que l'ouverture (28) pratiquée dans le panneau de surface (16) de la porte (10), ceci de façon à ce que la plaque recouvre l'ouverture indépendamment de la position de l'élément coulissant.
